# EUROPEAN PATENT SPECIFICATION

(11) **EP 3 656 896 B1**
(45) Date of publication and mention of the grant of the patent: **02.07.2025**
(21) Application number: 18835867.5
(22) Date of filing: 17.07.2018
(51) Int. Cl.: C30B 29/04, C23C 16/27, C30B 25/18, H01L 21/205, H01L 21/02, C23C 16/01, C23C 16/02

(54) **METHOD FOR PRODUCING DIAMOND LAMINATED SILICON WAFER, AND DIAMOND LAMINATED SILICON WAFER**
VERFAHREN ZUR HERSTELLUNG EINES DIAMANTLAMINIERTEN SILIZIUMWAFERS UND DIAMANTLAMINIERTER SILIZIUMWAFER
PROCÉDÉ DE PRODUCTION DE TRANCHE DE SILICIUM STRATIFIÉE DE DIAMANT, ET TRANCHE DE SILICIUM STRATIFIÉE DE DIAMANT

(30) Priority: 21.07.2017 JP 2017141860
(43) Date of publication of application: 27.05.2020
(73) Proprietor: SUMCO Corporation, Minato-ku Tokyo 105-8634 (JP)
(72) Inventor: KOGA, Yoshihiro, Tokyo 105-8634 (JP)
(74) Representative: Kraus & Lederer PartGmbB
(86) International application number: PCT/JP2018/026715
(87) International publication number: WO 2019/017330

(56) References cited:
- EP-A1- 0 844 319
- GB-A- 2 254 733
- JP-A- 2009 091 234
- JP-A- 2010 070 405
- JP-A- 2012 076 982
- JP-A- H1 081 589
- DENNIG P A ET AL: "Influence of substrate treatments on diamond thin film nucleation", THIN SOLID FILMS, ELSEVIER, AMSTERDAM, NL, vol. 212, no. 1-2, 15 May 1992 (1992-05-15), pages 63 - 67, XP025730602, ISSN: 0040-6090, [retrieved on 19920515], DOI: 10.1016/0040-6090(92)90501-2
- VEDDE JAN ET AL: "The fracture strength of nitrogen doped silicon wafers", MATERIALS SCIENCE AND ENGINEERING: B, vol. 36, no. 1, 1996, pages 246 - 250, XP028697450, ISSN: 0921-5107, DOI: 10.1016/0921-5107(95)01258-3

## Description

### TECHNICAL FIELD

This disclosure relates to a method of producing a diamond-on-silicon wafer in which a diamond layer is formed on a silicon wafer and a diamond-on-silicon wafer.

### BACKGROUND

Since diamond has a wide band gap, diamond-on-silicon wafers, in which a diamond layer is formed on a silicon wafer, are widely used as a wide band gap semiconductor suitable for gas sensing devices, temperature sensing devices, radiation/infrared radiation detecting devices, etc.

As a typical method of producing a diamond-on-silicon wafer, a technique of attaching diamond particles to a surface of a silicon wafer and growing a diamond layer from the attached diamond particles as nuclei is used. For example, JP 2005-306617 A proposes attaching diamond particles having a radius of 50 nm or less that is close to the critical radius for nucleation to a surface of a silicon wafer and then growing a diamond layer by chemical vapor deposition (CVD). JP 2005-306617 A reports that since diamond particles having a radius close to the critical radius for nucleation are used, the surface roughness of the diamond layer is reduced. Furthermore, EP 0 844 319 A1 discloses a method to produce a diamond film formed from growth nuclei distributed on a substrate. EP 0 844 319 A1 reports that using this method extremely thin continuous films of about 0.5 µm or less can be obtained.

### SUMMARY

### (Technical Problem)

In recent years, with a view to further improving the device characteristics of gas sensing devices, temperature sensing devices, radiation/infrared radiation detecting devices, etc., there is a demand for diamond-on-silicon wafers having diamond particles of reduced particle size in a diamond layer. Further, when a diamond-on silicon wafer is used as a vertical device, the thickness of a diamond layer is required to be 10 µm or more. However, even in the case where the diamond particles attached to a silicon wafer as nuclei for growing a diamond layer are fine particles of 50 nm or less are used as in JP 2005-306617 A, when the diamond layer is thick, the particle size of the diamond particles in the diamond layer is not reduced, and it was found that when a device is formed in such a diamond layer, leak currents are increased and the device characteristics would be deteriorated.

To address the above problem, it could be helpful to provide a method of producing a diamond-on silicon wafer in which the particle size of diamond particles in a diamond layer is reduced, and a diamond-on-silicon wafer.

### (Solution to Problem)

We diligently studied to solve the above problem and found that the above leak currents would increase when the particle size of the diamond particles in the diamond layer exceeds the gate width (approximately 2 µm) of the device. We further studied to reduce the particle size of diamond particles in a diamond layer and found a correlation between the oxygen concentration in a silicon wafer and the particle size of the diamond particles in the diamond layer. We also found that when a silicon wafer having an oxygen concentration of 5 × 10¹⁷ atom/cm³ or less was used as a base substrate of the diamond layer, the maximum particle size of the diamond particles in the diamond layer could be controlled to 2 µm or less even if the diamond layer was thick.

This disclosure is based on the above findings, and we propose a method of producing a diamond-on-silicon wafer according to claim 1 and a diamond-on-silicon wafer according to claim 5. The dependent claims define further embodiments.

In particular, we propose the features defined in the appended claims.

### (Advantageous Effect)

According to this disclosure, a diamond-on-silicon wafer in which the particle size of diamond particles in a diamond layer is reduced can be obtained.

### BRIEF DESCRIPTION OF THE DRAWINGS

In the accompanying drawings:
FIGS. 1A to 1D are schematic cross-sectional views illustrating a method of producing a diamond-on-silicon wafer 100 of one embodiment;
FIG. 2 presents photographs taken by optical microscopy on a surface of a diamond layer in Examples 1 to 3 and Comparative Example 1; and
FIG. 3 presents photographs depicting cases where peeling of a diamond layer was observed and not observed in Examples 7 and 8.

### DETAILED DESCRIPTION

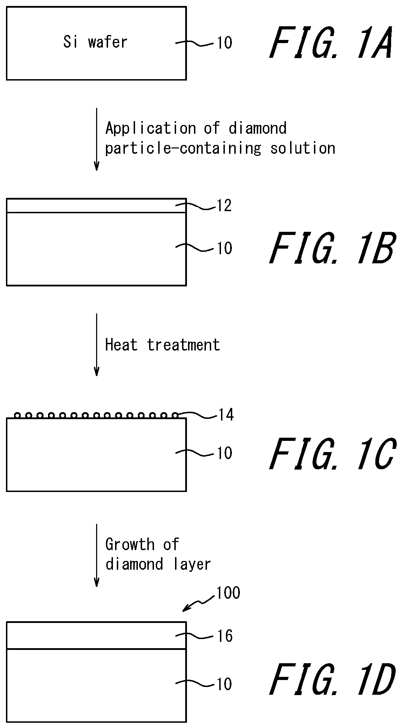

An embodiment of this disclosure will now be described with reference to the drawings. Note that in FIG. 1, the thickness of a diamond particle coated layer 12, the particle size of diamond particles 14, and the thickness of a diamond layer 16 are exaggerated relative to a silicon wafer 10 for the sake of explanation; accordingly, the ratio between the dimensions does not conform to the actual ratio.

### (Method of producing diamond-on-silicon wafer)

One embodiment of a diamond-on-silicon wafer is depicted in FIGS. 1A to 1D.

Referring to FIG. 1, a method of producing a diamond-on-silicon wafer 100 according to one embodiment is described. First, a silicon wafer 10 having an oxygen concentration of 5 × 10¹⁷ atom/cm³ or less is prepared (FIG. 1(A)). Next, a diamond particle-containing solution is applied to the surface of the silicon wafer 10 (FIGS. 1A and 1B). Thus, the diamond particle coated layer 12 is formed on the silicon wafer 10 (FIG. 1B). Next, the silicon wafer 10 is subjected to heat treatment thereby evaporating the solvent in the diamond particle coated layer 12 and strengthening the bond between the surface of the silicon wafer 10 and diamond particles 14; thus, the diamond particles 14 are attached to the surface of the silicon wafer 10 (FIGS. 1B and 1C). Next, a diamond layer 16 is grown on the silicon wafer 10 by CVD using the attached diamond particles 14 as nuclei (FIGS. 1C and 1D). In this manner, a diamond-on-silicon wafer 100 is fabricated. The steps of this embodiment will now be described in detail.

### (Preparing silicon wafer)

Referring to FIG. 1A, the silicon wafer 10 having an oxygen concentration of 5 × 10¹⁷ atom/cm³ or less is prepared. The "oxygen concentration of the silicon wafer" herein means the mean value of the oxygen concentrations in the thickness direction of the silicon wafer 10, measured by FT-IR spectroscopy according to Old ASTM F121-1979. As will be described in detail, when such a silicon wafer having a low oxygen concentration is used, the out diffusion of oxygen in the silicon wafer 10 to the diamond layer 16 during the growth of the diamond layer 16 depicted in FIGS. 1C and 1D is suppressed, thus the maximum particle size of the diamond particles in the diamond layer 16 can be controlled to 2.0 µm or less. The thickness of the silicon wafer 10 may be set depending on the thickness of the diamond layer 16 to be formed. Specifically, since the warpage of the diamond-on-silicon wafer 100 is more significant when the diamond layer 16 is thicker, the silicon wafer 10 is preferably thick with a view to preventing the warpage. In particular, the thickness of the silicon wafer 10 is preferably 280 µm or more and 10 cm or less.

Further, the resistivity of the silicon wafer 10 is preferably 1000 Ω·cm or more. Such a silicon wafer having high resistivity contains few impurities serving as carriers, such as boron and phosphorus, which prevents those impurities from being out-diffused to the diamond layer 16 during the growth of the diamond layer 16. Consequently, the resistance variation in the diamond layer 16 can be prevented.

### (Applying diamond particle-containing solution)

Next, referring to FIGS. 1A and 1B, the diamond particle-containing solution is applied to the surface of the silicon wafer 10 thereby forming a diamond particle coated layer 12. Preferred conditions for forming the diamond particle coated layer 12 will be described in detail below.

The average particle size of the diamond particles contained in the diamond particle-containing solution is 50 nm or less and preferably 1 nm or more. When the average particle size is 1 nm or more, the diamond particles 14 can be prevented from being flicked off the surface of the silicon wafer 10 by the sputtering effect, in early stages of growing of the diamond layer 16. With the average particle size being 50 nm or less, the maximum particle size of the diamond particles in the diamond layer 16 is 2.0 µm or less even when the thickness of the diamond layer 16 is 10 µm or more. Such diamond particles can be suitably produced from graphite by a known method such as detonation, implosion, or pulverization. Note that "the average particle size of the diamond particles contained in the diamond particle-containing solution" is calculated based on JIS 8819-2, and means the average particle size calculated on the assumption that the size distribution found using a known laser diffraction particle size analyzer conforms to the normal distribution.

Before being coated with the diamond particle-containing solution, the silicon wafer 10 is typically pickled using, for example, hydrofluoric acid to remove metal impurities deposited on its surface. The surface of the pickled silicon wafer 10 is a repellent surface, and since the repellent surface is active, the particles easily adhere. Therefore, the pickled silicon wafer 10 is preferably washed with pure water or the like to make the surface of the silicon wafer 10 to have a hydrophilic surface on which a natural oxide layer is formed. Alternatively, the pickled silicon wafer 10 is preferably left in a clean room for a long time to form a natural oxide layer on the surface of the silicon wafer 10. Thus, the particles can be prevented from being attached to the surface of the silicon wafer 10. At this point, positive fixed charges are generated in the natural oxide layer. Accordingly, when the diamond particle-containing solution containing negatively charged diamond particles is applied to the surface of the positively charged natural oxide layer, the silicon wafer 10 and the diamond particles 14 are firmly bonded together due to the Coulomb attraction. This contributes to the improvement in the adhesion of the diamond layer 16 to the silicon wafer 10. Such negatively charged diamond particles can be obtained by performing oxidation on the diamond particles to terminate the diamond particles by carboxyl groups or ketone groups. Examples of the oxidation process include methods in which diamond particles are oxidized by heat and methods in which diamond particles are immersed in an ozone solution, a nitric acid solution, a hydrogen peroxide aqueous solution, or a perchloric acid solution.

Examples of a solvent for the diamond particle-containing solution include, in addition to water, organic solvents such as methanol, ethanol, 2-propanol, and toluene. One of these solvents can be used alone or two or more of them can be used in combination.

The content of the diamond particles in the diamond particle-containing solution is preferably 0.03 % by mass or more and 10 % by mass or less with respect to the entire diamond particle-containing solution. When the content is 0.03 % by mass or more, the diamond particles 14 can be attached to the surface of the silicon wafer 10 to be uniform in the wafer surface by heat treatment illustrated in FIGS. 1B and 1C and can be used as growth nuclei. When the content is 10 % by mass or less, the attached diamond particles 14 can suppress the abnormal growth of the diamond layer 16 depicted in FIGS. 1C and 1D in the growth process.

In view of improving the adhesion between the diamond particles 14 and the silicon wafer 10, the diamond particle-containing solution is preferably in the form of a gel. Alternatively, a thickener may be contained in the diamond particle-containing solution. Examples of the thickener include agar, carrageenan, xanthan gum, gellan gum, guar gum, polyvinyl alcohol, polyacrylate-based thickeners, water-soluble celluloses, and polyethylene oxide. One or more of them can be used. When the thickener is contained, the pH of the diamond particle-containing solution is preferably in the range of 6 to 8.

The diamond particle-containing solution may be prepared by mixing and stirring diamond particles in the above solvent so that the diamond particles are dispersed in the solvent. The stirring speed is preferably 500 rpm to 3000 rpm, and the steering time is preferably 10 minutes to 1 hour.

The diamond particle-containing solution prepared as described above is applied to the surface of the silicon wafer 10 (FIGS. 1A and 1B). Here, as a method for applying the diamond particle-containing solution, for example, a known spin coating method can be used. Spin coating allows the diamond particle-containing solution to be uniformly applied to only one of the surfaces of the wafer that is intended to be coated with the diamond particles.

### (Heat treatment)

Next, referring to FIGS. 1B and 1C, heat treatment is performed on the silicon wafer 10. This evaporates the solvent in the diamond particle coated layer 12, so that the diamond particles 14 are attached to the surface of the silicon wafer 10 (FIG. 1C). Performing heat treatment can increase the adhesion between the diamond particles 14 and the silicon wafer 10. The temperature of the wafer during heat treatment is preferably less than 100 °C, more preferably 30 °C or more and 80 °C or less. When the temperature is 100 °C or more, bubbles are formed during the boiling of the diamond particle-containing solution, thus the diamond particles would not be attached to part of the support substrate 10. If there is a portion where the diamond particles are not attached, peeling of the diamond layer 16 would be initiated from the portion. When the temperature is less than 30 °C, the bond between the silicon wafer 10 and the diamond particles 14 is weak; thus, the diamond particles 14 are flicked off due to the sputtering effect during the growth of the diamond layer 16 by CVD. This would make it difficult to grow a uniform diamond layer. Further, the heat treatment time is preferably 1 min to 30 min. As a heat treatment apparatus, a known heat treatment apparatus can be used; for example, heat treatment can be performed by placing the silicon wafer 10 on a heated hot plate.

### (Growing diamond layer)

Next, referring to FIGS. 1C and 1D, the diamond layer 16 is grown on the silicon wafer 10 by a CVD process under typical conditions using as growth nuclei the diamond particles 14 attached to the surface of the silicon wafer 10. For the CVD process, plasma-enhanced CVD, hot-filament CVD, etc. can be suitably used.

When plasma-enhanced CVD is used, for example, the diamond layer 16 is grown at a wafer temperature of 700 °C to 1300 °C by introducing a source gas such as methane into a chamber using hydrogen as a carrier gas. In terms of further improving the uniformity of the thickness of the diamond layer 16, microwave plasma-assisted CVD is preferably used. Microwave plasma-assisted CVD is a method in which a source gas such as methane is digested by microwaves to form plasma in a plasma chamber and the source gas forming a plasma is delivered to the heated silicon wafer 10 thereby growing the diamond layer 16. Here, the pressure in the plasma chamber, the output of the microwaves, and the temperature of the wafer are preferably set as follows. The pressure in the plasma chamber is preferably 10 Torr to 1000 Torr, more preferably 80 Torr to 300 Torr. The output of the microwaves is preferably 0.1 kW to 100 kW, more preferably 1 kW to 10 kW. The temperature of the wafer is preferably 700 °C to 1300 °C, more preferably 900 °C to 1200 °C.

When hot-filament CVD is used, carbon radicals are generated from a hydrocarbon-based source gas such as methane using a filament made of tungsten, tantalum, rhenium, molybdenum, iridium, or the like at a filament temperature of approximately 1900 °C to 2300 °C. The carbon radicals are directed to the heated silicon wafer 10 thereby growing the diamond layer 16. Hot-filament CVD can easily be applied to larger diameter wafers. Here, the pressure in the chamber, the distance between the filament and the silicon wafer 10, and the temperature of the wafer are preferably set as follows. The pressure in the chamber is preferably 10 Torr to 1000 Torr. The distance between the filament and the silicon wafer 10 is preferably 5 mm to 20 mm. The temperature of the wafer is preferably 700 °C to 1300 °C.

Note that the thickness of the diamond layer 16 to be grown can be selected depending on the intended use of the diamond-on-silicon wafer 100. For example, when the diamond layer 16 is used as an active layer for forming a device in the lateral direction (horizontal direction) for example as in high frequency devices, a diamond layer having a thickness of 0.1 µm to 1 mm is required. On the other hand, when the diamond layer 16 is used as an active layer for forming a device in the upright direction (vertical direction) for example as in power devices, a diamond layer having a thickness of 10 µm to 1 mm is required.

A feature of this embodiment is that a silicon wafer 10 of low oxygen with an oxygen concentration of 5.0 × 10¹⁷ atoms/cm³ or less is used as the base substrate of the diamond layer 16. The mechanism of the reduction in the size of the diamond particles in the diamond layer 16 with the use of the silicon wafer of low oxygen is assumed as follows.

When the oxygen concentration of the silicon wafer 10 exceeds 5 × 10¹⁷ atom/cm³, oxygen diffused out of the silicon wafer 10 due to heat in the process of the growth of the diamond layer preferentially etches a graphite (sp² orbital) region with weak binding force, constituting growing diamond particles, thus only a diamond (sp³ orbital) region with high binding force is assumed to rapidly grow. Accordingly, the particle size of the diamond particles is large and the surface of the diamond particles is significantly rough, resulting in large gaps between the diamond particles, thus the density of the diamond layer 16 would be low. On the other hand, since the out diffusion of oxygen is suppressed when a silicon wafer of low oxygen is used, etching of the graphite region is suppressed, so that the diamond region is grown while the graphite region is etched in plasma, thus the rapid growth of the diamond region would be mitigated. Consequently, a closely packed diamond layer 16 having diamond particles with a maximum particle size of 2.0 µm or less is thought to be obtained. Considering this, a gas which does not contain oxygen is preferably used as a carrier gas used in growing the diamond layer 16 in terms of suppressing etching of the graphite region.

A method of producing a diamond-on-silicon wafer has been described using this embodiment as an example; however, this disclosure is not limited to the above embodiment, and modifications may be made as appropriate without departing from the scope defined by the claims.

The method of attaching the diamond particles to the surface of the silicon wafer is not limited to the application method, and may be a known method such as a dip coating method or a scratching method. When a dip coating method is used, diamond particles are attached to the surface of the silicon wafer by performing the above-mentioned heat treatment after the silicon wafer is dipped in the diamond particle-containing solution. In the case of a scratching method, diamond particles are embedded into the surface of the silicon wafer, thus the diamond particles are attached to the surface of the silicon wafer. Examples of the method of embedding the diamond particles include: (1) a method of distributing diamond powder in a dried state on the surface of the silicon wafer and applying a pressing force to the wafer surface, (2) a method of sending a blast of a high speed gas containing diamond particles to the surface of the silicon wafer, (3) a method of placing the silicon wafer in a fluidized bed of diamond particles, and (4) a method of performing ultrasonic cleaning on the silicon wafer in a solution in which diamond particles are distributed. In the scratching method, when variation in the depth of the diamond particles results in a non-uniform thickness of the diamond layer, and when the surface of the silicon wafer is greatly damaged during the embedding of the diamond particles, for example, the smoothness of the surface of the diamond layer would be deteriorated. Therefore, an application method or a dip coating method is preferably used.

Further, the silicon wafer 10 may be a (100) wafer. In this case, part of the diamond layer excluding a device region formed in the diamond layer may be removed (etched) to fabricate a device (for example, a CMOS device, a memory device, a CIS device, or an IGBT device) in the silicon wafer, thus the device formed in the diamond layer, and the device formed in the silicon wafer can be made into a System on Chip (SoC).

### (Diamond-on-silicon wafer)

Referring to FIG. 1D, the diamond-on-silicon wafer 100 obtainable by the above production method will be described. The diamond-on-silicon wafer 100 has the silicon wafer 10 having an oxygen concentration of 5.0 × 10¹⁷ atoms/cm³ or less, and the diamond layer 16 formed on the silicon wafer 10. The maximum particle size of diamond particles in the diamond layer 16 is 2.0 µm or less.

The "maximum particle size of the diamond particles in the diamond layer" in this specification is defined as follows. Three regions of a wafer that are 10 µm × 10 µm in size are observed under an optical microscope. The three regions are centered at three points, that is, the center of the wafer and the two intersection points between a wafer diameter and the circumference of a circle having a radius which is 95 % of the radius of the wafer radius, the circle being centered at the wafer center. The maximum particle size of all the diamond particles in those three regions is defined as "maximum particle size of the diamond particles in the diamond layer". Note that "particle size of a diamond particles" refers to the length of the major axis of the diamond particle.

The thickness of the silicon wafer 10 is preferably 280 µm or more and 10 cm or less, the resistivity of the silicon wafer 10 is preferably 1000 Ω·cm or more, and the silicon wafer 10 is preferably a (100) wafer. Further, when the diamond layer 16 is used as an active layer for forming a device in the lateral direction for example as in high frequency devices, the thickness of the diamond layer is preferably 0.1 µm to 1 mm; when the diamond layer 16 is used as an active layer for forming a device in the upright direction for example as in power devices, the thickness of the diamond layer 16 is preferably 10 µm to 1 mm. For the detailed reasons for these values, refer to the description above.

A diamond-on-silicon wafer has been described using this embodiment as an example; however, this disclosure is not limited to the above embodiment, and modifications may be made as appropriate without departing from the scope defined by the claims.

### EXAMPLES

### < Experiment 1 >

In Experiment 1, diamond-on-silicon wafers of Examples 1 to 6, and Comparative Examples 1 and 2 were fabricated in accordance with the method described below, and the density of the diamond layer was determined.

### (Example 1)

Through the steps depicted in FIGS. 1A to 1D, a diamond-on-silicon wafer was fabricated.

First, a silicon wafer having a diameter of 2 in, a thickness of 3 mm, a (100) crystallographic plane, a resistivity of 1000 Ω·cm, and an oxygen concentration (ASTM F121-1979) of 5.0 × 10¹⁷ atoms/cm³ was prepared by cutting a silicon single crystal ingot grown by the magnetic Czochralski (MCZ) process (FIG. 1A).

Next, as diamond particles, diamond particles having an average particle size of 4 nm, produced by detonation were used. The diamond particles were immersed in a hydrogen peroxide aqueous solution to be terminated by carboxyl groups (COOH), thus the diamond particles were negatively charged. Next, a diamond particle-containing solution was prepared by mixing and stirring the diamond particles in a solvent (H₂O) such that the concentration of the diamond particles with respect to the entire solution was 0.1 % by mass. The stirring speed was 1100 rpm, the stirring time was 50 min, and the temperature of the diamond particle-containing solution during the stirring was 25 °C. Subsequently, the silicon wafer was cleaned with pure water, and the diamond particle-containing solution was applied by spin coating to a surface of the silicon wafer on which a natural oxide layer was formed; thus, a diamond particle coated layer was formed on the silicon wafer (FIGS. 1A and 1B).

Next, the silicon wafer was placed on a hot plate heated to 80 °C, for 3 minutes to perform heat treatment for strengthening the bond between the silicon wafer and the diamond particles; thus, the diamond particles were attached to the surface of the silicon wafer (FIGS. 1B and 1C).

Next, a diamond layer with a thickness of 10 µm was grown on the silicon wafer by the above-described microwave plasma-assisted CVD using hydrogen as a carrier gas, methane as a source gas, and the diamond particles attached to the silicon wafer as growth nuclei (FIGS. 1C and 1D). In the growth of the diamond layer, the pressure in the plasma chamber was 135 Torr, the output of the microwaves was 5 kW, the wafer temperature was 1050 °C, and the growth time was 2 h. Thus, a diamond-on-silicon wafer was obtained.

### (Example 2)

In Example 2, a diamond-on-silicon wafer was produced in the same manner as in Example 1, except that a silicon wafer having an oxygen concentration of 2 × 10¹⁷ atom/cm³, prepared by the MCZ process was used.

### (Example 3)

In Example 3, a diamond-on-silicon wafer was produced in the same manner as in Example 1, except that a silicon wafer having an oxygen concentration of 6 × 10¹⁶ atom/cm³, prepared by the floating zone (FZ) process was used.

### (Example 4)

In Example 4, a diamond-on-silicon wafer was produced in the same manner as in Example 1, except that the thickness of the diamond layer was 1000 µm.

### (Example 5)

In Example 5, a diamond-on-silicon wafer was produced in the same manner as in Example 2, except that the thickness of the diamond layer was 1000 µm.

### (Example 6)

In Example 6, a diamond-on-silicon wafer was produced in the same manner as in Example 3, except that the thickness of the diamond layer was 1000 µm.

### (Comparative Example 1)

In Comparative Example 1, a diamond-on-silicon wafer was produced in the same manner as in Example 1, except that a silicon wafer having an oxygen concentration of 1 × 10¹⁸ atom/cm³ was used.

### (Comparative Example 2)

In Comparative Example 2, a diamond-on-silicon wafer was produced in same manner as in Comparative Example 1, except that the thickness of the diamond layer was 1000 µm.

### (Evaluation method)

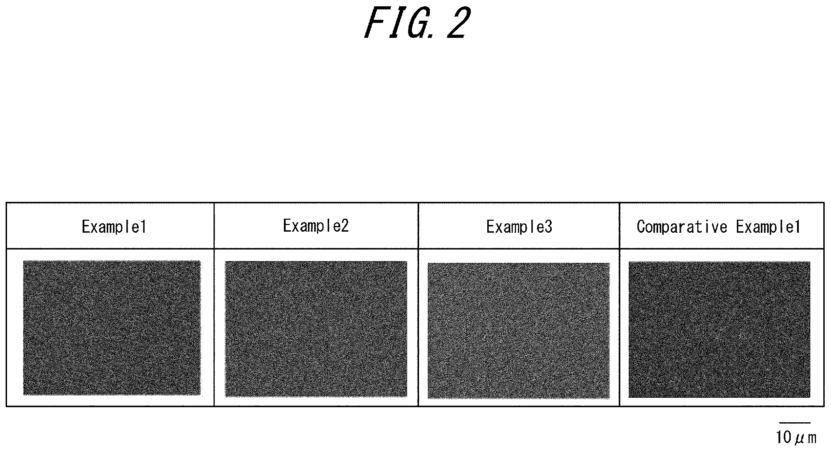

In each of Examples and Comparative Examples, the maximum particle size of the diamond particles in the diamond layer was found by the above-mentioned method, and the density of the diamond layer was determined. The measurement results are given in Table 1. Further, FIG. 2 presents photographs of the center of the diamond layer surface, observed under the above-described optical microscope in Examples 1 to 3 and Comparative Example 1. Here, in FIG. 2, white portions correspond to diamond particles, and black portions correspond to a base silicon wafer.

**Table 1**

| | Sample preparation conditions | | Evaluation results |
|---|---|---|---|
| | Oxygen concentration of Si wafer (atoms/cm³) | Thickness of Diamond layer (µm) | Maximum particle size of Diamond particles in Diamond layer (µm) |
| Example 1 | 5 × 10¹⁷ | 10 | 1.8 |
| Example 2 | 2 × 10¹⁷ | 10 | 1.5 |
| Example 3 | 6 × 10¹⁶ | 10 | 1.2 |
| Example 4 | 5 × 10¹⁷ | 1000 | 1.9 |
| Example 5 | 2 × 10¹⁷ | 1000 | 1.7 |
| Example 6 | 6 × 10¹⁶ | 1000 | 1.4 |
| Comparative Example 1 | 1 × 10¹⁸ | 10 | 3.0 |
| Comparative Example 2 | 1 × 10¹⁸ | 1000 | 3.9 |

### (Description of evaluation results)

In Comparative Examples 1 and 2, in which a silicon wafer having an oxygen concentration exceeding 5 × 10¹⁷ atom/cm³ was used, the maximum particle size of the diamond particles in the diamond layer exceeded 2.0 µm, whereas in each of Examples 1 to 6, in which a silicon wafer having an oxygen concentration of 5 × 10¹⁷ atom/cm³ or less was used, the maximum particle size of the diamond particles in the diamond layer was 2.0 µm or less. Thus, denser diamond layers were obtained in Examples 1 to 6 as compared with Comparative Examples 1 and 2. The use of a low oxygen silicon wafer with an oxygen concentration of 5 × 10¹⁷ atom/cm³ or less is considered to have suppressed the out diffusion of oxygen to the diamond layer from the silicon wafer.

### < Experiment 2 >

In Experiment 2, diamond-on-silicon wafers of Examples 7 and 8 were fabricated in accordance with the method described below, and the adhesion of the diamond layer was determined. Specifically, when negatively charged diamond particles were attached to a silicon wafer and when positively charged diamond particles were attached to a silicon wafer, polishing was performed after growing a diamond layer, and whether the diamond layer had peeled or not was determined.

### (Example 7)

In Example 7, after fabricating a diamond-on-silicon wafer by the same method as in Example 1, mirror polishing was performed to remove a 1 µm thick layer of the surface of the diamond layer by chemical mechanical polishing (CMP). That is, Example 7 is an experimental example in which diamond particles formed by detonation were immersed in a hydrogen peroxide aqueous solution to terminate diamond particles by carboxyl groups (COOH) thereby negatively charging the diamond particles.

### (Example 8)

In Example 8, a diamond-on-silicon wafer was prepared by the same method as in Example 1, except that the diamond particles were positively charged and the surface of the diamond layer was then mirror polished in the same manner as in Example 7. In order to positively charge diamond particles, diamond particles may be terminated by hydrogen or amino groups; for example, a method of performing plasma treatment in a hydrogen atmosphere or a method of performing plasma treatment in an ammonia atmosphere can be used. In Example 8, diamond particles formed by detonation were subjected to plasma treatment in an ammonia atmosphere to terminate the diamond particles by amino groups (NH₂), thus the diamond particles were positively charged.

### (Evaluation method)

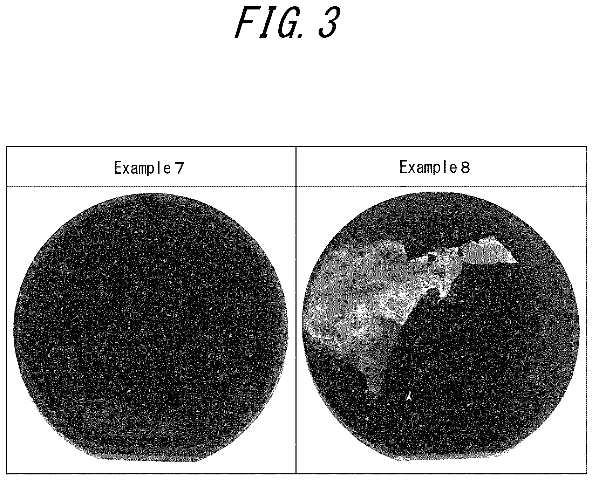

In Examples 7 and 8, whether or not peeling of the diamond layer was found in the surface of the diamond layer was determined by visual observation, thereby determining the adhesion. The observation results are given in FIG. 3.

### (Description of evaluation results)

In Example 8, in which the diamond particles were positively charged, the surface of the diamond layer peeled, whereas in Example 7, in which the diamond particles were negatively charged, peeling of the surface of the diamond layer did not occur. The Coulomb force between the positively charged natural oxide layer sitting on the surface of the silicon wafer and the negatively charged diamond particles is assumed to have improved the adhesion of the diamond layer.

### INDUSTRIAL APPLICABILITY

According to this disclosure, a diamond-on-silicon wafer in which the particle size of diamond particles in a diamond layer is reduced is obtained.

### REFERENCE SIGNS LIST

100: Diamond-on-silicon wafer
10: Silicon wafer
12: Diamond particle coated layer
14: Diamond particle
16: Diamond layer

## Claims

1. A method of producing a diamond-on-silicon wafer comprising:
attaching diamond particles to a surface of a silicon wafer having an oxygen concentration of 5 × 10¹⁷ atom/cm³ or less, and
then growing a diamond layer on the silicon wafer by chemical vapor deposition using the diamond particles as nuclei,
wherein a maximum particle size of the diamond particles defined as the maximum length of the major axis of the diamond particle in the diamond layer is 2.0 µm or less,
wherein the maximum particle size of the diamond particles in the diamond layer was determined by observing three regions of the wafer that are 10 µm × 10 µm in size under an optical microscope,
wherein the three regions are centered at three points, that is, the center of the wafer and the two intersection points between a wafer diameter and the circumference of a circle having a radius which is 95 % of the radius of the wafer radius, the circle being centered at the wafer center, and wherein the maximum particle size of all the diamond particles in the three regions is defined as the maximum particle size,
wherein a thickness of the diamond layer is 10 µm or more,
wherein the oxygen concentration means the mean value of the oxygen concentrations in a thickness direction of the silicon wafer, measured by FT-IR spectroscopy according to Old ASTM F121-1979,
wherein either after a diamond particle-containing solution is applied to the surface of the silicon wafer or after the silicon wafer is dipped in a diamond particle-containing solution, heat treatment is performed on the silicon wafer, thereby attaching the diamond particles to the surface of the silicon wafer,
wherein an average particle size, measured by a laser diffraction particle size analyzer and calculated based on JIS 8819-2, of the diamond particles in the diamond particle-containing solution is 50 nm or less.

2. The method of producing a diamond-on-silicon wafer, according to Claim 1, wherein diamond particles in the diamond particle-containing solution are negatively charged.

3. The method of producing a diamond-on-silicon wafer, according to Claim 1 or 2, wherein a temperature of the silicon wafer is less than 100 °C in the heat treatment.

4. The method of producing a diamond-on-silicon wafer, according to any one of Claims 1 to 3, wherein a resistivity of the silicon wafer is 1000 Ω·cm or more.

5. A diamond-on-silicon wafer comprising a silicon wafer having an oxygen concentration of 5 × 10¹⁷ atom/cm³ or less and a diamond layer formed on the silicon wafer,
wherein a maximum particle size of diamond particles defined as the maximum length of the major axis of the diamond particle in the diamond layer is 2.0 µm or less,
wherein the maximum particle size of the diamond particles in the diamond layer was determined by observing three regions of the wafer that are 10 µm × 10 µm in size under an optical microscope,
wherein the three regions are centered at three points, that is, the center of the wafer and the two intersection points between a wafer diameter and the circumference of a circle having a radius which is 95 % of the radius of the wafer radius, the circle being centered at the wafer center, and wherein the maximum particle size of all the diamond particles in the three regions is defined as the maximum particle size,
wherein a thickness of the diamond layer is 10 µm or more, and
wherein the oxygen concentration means the mean value of the oxygen concentrations in a thickness direction of the silicon wafer, measured by FT-IR spectroscopy according to Old ASTM F121-1979.

6. The diamond-on-silicon wafer according to Claim 5, wherein a resistivity of the silicon wafer is 1000 Ω·cm or more.

## Patentansprüche

1. Verfahren zur Herstellung eines Diamant-auf-Silicium-Wafers, umfassend:
Anbringen von Diamantpartikeln an einer Oberfläche eines Silicium-Wafers mit einer Sauerstoffkonzentration von 5 x 10¹⁷ Atom/cm³ oder weniger, und
dann Aufwachsen einer Diamantschicht auf dem Silicium-Wafer durch chemische Gasphasenabscheidung unter Verwendung der Diamantpartikel als Keime,
wobei eine maximale Partikelgröße der Diamantpartikel, die als die maximale Länge der Hauptachse des Diamantpartikels in der Diamantschicht definiert ist, 2,0 µm oder weniger beträgt,
wobei die maximale Partikelgröße der Diamantpartikel in der Diamantschicht durch Beobachten von drei Bereichen des Wafers, die eine Größe von 10 µm x 10 µm aufweisen, unter einem optischen Mikroskop bestimmt wurde,
wobei die drei Bereiche an drei Punkten zentriert sind, das heißt, der Mitte des Wafers und den zwei Schnittpunkten zwischen einem Waferdurchmesser und dem Umfang eines Kreises mit einem Radius, der 95% des Radius des Waferradius beträgt, wobei der Kreis in der Wafermitte zentriert ist, und wobei die maximale Partikelgröße aller Diamantpartikel in den drei Bereichen als die maximale Partikelgröße definiert ist,
wobei eine Dicke der Diamantschicht 10 µm oder mehr beträgt,
wobei die Sauerstoffkonzentration den Mittelwert der Sauerstoffkonzentrationen in einer Dickenrichtung des Silicium-Wafers bedeutet, gemessen durch FT-IR-Spektroskopie gemäß Old ASTM F121-1979,
wobei entweder nachdem eine diamantpartikelhaltige Lösung auf die Oberfläche des Silicium-Wafers aufgebracht wurde oder nachdem der Silicium-Wafer in eine diamantpartikelhaltige Lösung getaucht wurde, eine Wärmebehandlung an dem Silicium-Wafer durchgeführt wird, wodurch die Diamantpartikel an der Oberfläche des Silicium-Wafers angebracht werden,
wobei eine durchschnittliche Partikelgröße, gemessen durch einen Laserbeugungs-Partikelgrößenanalysator und berechnet basierend auf JIS 8819-2, der Diamantpartikel in der diamantpartikelhaltigen Lösung 50 nm oder weniger beträgt.

2. Verfahren zur Herstellung eines Diamant-auf-Silicium-Wafers nach Anspruch 1, wobei Diamantpartikel in der diamantpartikelhaltigen Lösung negativ geladen sind.

3. Verfahren zur Herstellung eines Diamant-auf-Silicium-Wafers nach Anspruch 1 oder 2, wobei eine Temperatur des Silicium-Wafers bei der Wärmebehandlung weniger als 100°C beträgt.

4. Verfahren zur Herstellung eines Diamant-auf-Silicium-Wafers nach einem der Ansprüche 1 bis 3, wobei ein spezifischer Widerstand des Silicium-Wafers 1000 Ω·cm oder mehr beträgt.

5. Diamant-auf-Silicium-Wafer, umfassend einen Silicium-Wafer mit einer Sauerstoffkonzentration von 5 x 10¹⁷ Atom/cm³ oder weniger und eine auf dem Silicium-Wafer gebildete Diamantschicht,
wobei eine maximale Partikelgröße von Diamantpartikeln, die als die maximale Länge der Hauptachse des Diamantpartikels in der Diamantschicht definiert ist, 2,0 µm oder weniger beträgt,
wobei die maximale Partikelgröße der Diamantpartikel in der Diamantschicht durch Beobachten von drei Bereichen des Wafers, die eine Größe von 10 µm x 10 µm aufweisen, unter einem optischen Mikroskop bestimmt wurde,
wobei die drei Bereiche an drei Punkten zentriert sind, das heißt, der Mitte des Wafers und den zwei Schnittpunkten zwischen einem Waferdurchmesser und dem Umfang eines Kreises mit einem Radius, der 95% des Radius des Waferradius beträgt, wobei der Kreis in der Wafermitte zentriert ist, und wobei die maximale Partikelgröße aller Diamantpartikel in den drei Bereichen als die maximale Partikelgröße definiert ist,
wobei eine Dicke der Diamantschicht 10 µm oder mehr beträgt, und
wobei die Sauerstoffkonzentration den Mittelwert der Sauerstoffkonzentrationen in einer Dickenrichtung des Silicium-Wafers bedeutet, gemessen durch FT-IR-Spektroskopie gemäß Old ASTM F121-1979.

6. Diamant-auf-Silicium-Wafer nach Anspruch 5, wobei ein spezifischer Widerstand des Silicium-Wafers 1000 Ω·cm oder mehr beträgt.

## Revendications

1. Un procédé de production d'une tranche de diamant sur silicium comprenant :
fixer des particules de diamant à une surface d'une tranche de silicium ayant une concentration en oxygène inférieure ou égale à 5 x 10¹⁷ atomes/cm³, et
puis faire croître une couche de diamant sur la tranche de silicium par dépôt chimique en phase vapeur, en utilisant les particules de diamant comme noyaux,
dans lequel une dimension maximum de particule des particules de diamant, définie comme la longueur maximum du grand axe de la particule de diamant dans la couche de diamant, est inférieure ou égale à 2,0 µm,
dans lequel on détermine la dimension maximum de particule des particules de diamant dans la couche de diamant en observant au microscope optique trois régions de la tranche, qui sont d'une dimension de 10 µm x 10 µm,
dans lequel les trois régions sont centrées en trois points, à savoir le centre de la tranche et les deux points d'intersection entre un diamètre de la tranche et la circonférence d'un cercle ayant un rayon, qui représente 95 % du rayon de la tranche, le cercle étant centré au centre de la tranche, et dans lequel la dimension maximum de particule de toutes les particules de diamant dans les trois régions est définie comme la dimension maximum de particule,
dans lequel une épaisseur de la couche de diamant est supérieure ou égale à 10 µm,
dans lequel la concentration en oxygène signifie la valeur moyenne des concentrations en oxygène dans une direction en épaisseur de la tranche de silicium, mesurée par spectroscopie IR-TF suivant Old ASTM F121-1979,
dans lequel soit après qu'une solution contenant des particules de diamant a été appliquée à la surface de la tranche de silicium, soit après que la tranche de silicium a été trempée dans une solution contenant des particules de diamant, on effectue un traitement thermique sur la tranche de silicium, en fixant ainsi les particules de diamant à la surface de la tranche de silicium,
dans lequel une dimension moyenne de particule, mesurée par un analyseur de dimension de particule par diffraction laser et calculée sur la base de JIS 8819-2, des particules de diamant dans la solution contenant des particules de diamant est inférieure ou égale à 50 nm.

2. Le procédé de production d'une tranche de diamant sur silicium suivant la revendication 1, dans lequel des particules de diamant dans la solution contenant des particules de diamant sont chargées négativement.

3. Le procédé de production d'une tranche de diamant sur silicium suivant la revendication 1 ou 2, dans lequel une température de la tranche de silicium est plus basse que 100°C dans le traitement thermique.

4. Le procédé de production d'une tranche de diamant sur silicium suivant l'une quelconque des revendications 1 à 3, dans lequel une résistivité de la tranche de silicium est supérieure ou égale à 1000 Ω cm.

5. Une tranche de diamant sur silicium comprenant une tranche de silicium ayant une concentration en oxygène inférieure ou égale à 5 x 10¹⁷ atomes/cm³ et une couche de diamant formée sur la tranche de silicium,
dans laquelle une dimension maximum de particule des particules de diamant, définie comme la longueur maximum du grand axe de la particule de diamant dans la couche de diamant, est inférieure ou égale à 2,0 µm,
dans laquelle on détermine la dimension maximum de particule des particules de diamant dans la couche de diamant en observant au microscope optique trois régions de la tranche, qui sont d'une dimension de 10 µm x 10 µm,
dans laquelle les trois régions sont centrées en trois points, à savoir le centre de la tranche et les deux points d'intersection entre un diamètre de la tranche et la circonférence d'un cercle ayant un rayon, qui représente 95 % du rayon de la tranche, le cercle étant centré au centre de la tranche, et dans laquelle la dimension maximum de particule de toutes les particules de diamant dans les trois régions est définie comme la dimension maximum de particule,
dans laquelle une épaisseur de la couche de diamant est supérieure ou égale à 10 µm, et
dans laquelle la concentration en oxygène signifie la valeur moyenne des concentrations en oxygène dans une direction en épaisseur de la tranche de silicium, mesurée par spectroscopie IR-TF suivant Old ASTM F121-1979.

6. La tranche de diamant sur silicium suivant la revendication 5, dans laquelle une résistivité de la couche de silicium est supérieure ou égale 1000 Ω cm.
